# EUROPÄISCHE PATENTANMELDUNG

(11) **EP 0 991 111 A1**
(43) Veröffentlichungstag der Anmeldung: **05.04.2000**
(21) Anmeldenummer: 99117452.5
(22) Anmeldetag: 09.09.1999
(51) Int. Cl.: H01L 21/00

(54) **Hordenaufnahmevorrichtung**

(30) Priorität: 02.10.1998 DE 19845504
(71) Anmelder: Wacker Siltronic Gesellschaft für Halbleitermaterialien Aktiengesellschaft, 84489 Burghausen (DE)
(72) Erfinder: Pritz, Günter, 84478 Waldkraiburg (DE)
(74) Vertreter: Schuderer, Michael, Dr.

(57) **Zusammenfassung**

Hordenaufnahmevorrichtung mit einer Befestigungsfläche 1, dadurch gekennzeichnet, daß sie zumindest zwei Seitenführungen 2 und zumindest einen Anschlag 3 aufweist, wobei der Anschlag 3 jeweils vor den zumindest zwei Seitenführungen 2 angeordnet ist und die zwei Seitenführungen 2 beabstandet parallel zueinander angeordnet sind, wobei die beiden Seitenführungen 2 so gestaltet sind, daß sie auf im wesentlichen gleicher Höhe eine Auflagefläche aufweisen.

## Beschreibung

Die Erfindung betrifft eine Hordenaufnahmevorrichtung.

Hordenaufnahmevorrichtungen für Horden, die Scheiben, wie Siliciumscheiben aufnehmen, sind bekannt. Die bekannten Hordenaufnahmevorrichtungen weisen lediglich Nuten und Stege auf, die in die Grundfläche gefräst sind, in die die Horden gestellt werden. Des weiteren befindet sich auf dieser Grundfläche ein Sensor, der registriert, daß die Horde in die Hordenaufnahmevorrichtung gesetzt worden ist oder sie wieder verlassen hat. Derartige Horden sind so aufgebaut, daß sie 25 Scheiben übereinander horizontal aufnehmen können. Diese Horden dienen als Aufbewahrungsbehälter und Transportbehälter. In derartigen Horden werden vorzugsweise Siliciumscheiben in einer Poliermaschine eingebracht, aus der sie ein Greifer nacheinander herausholt, um sie einem Polierverfahren zu unterziehen. Des gleichen geschieht in einer Meßvorrichtung, in der sie auf Fehler geprüft werden, und auch überall, wo Scheiben oder Siliziumscheiben horizontal gehandhabt werden.

Nachteilig an diesen Hordenaufnahmevorrichtungen ist, daß die Horden, die in ihnen verkanten, verzogen werden, oder die Horde selbst ist verzogen, so daß der Greifer die Scheiben nicht richtig zu fassen bekommt, so daß die wertvollen Scheiben zerstört oder beschädigt werden. Des weiteren können die Horden durchgebogen sein, so daß der Sensor nicht erkennt, daß sich eine Horde in der Hordenaufnahmevorrichtung befindet und die entsprechende Poliermaschine oder Meßvorrichtung nicht beginnt zu arbeiten.

Aufgabe der erfindungsgemäßen Vorrichtung ist es, die Nachteile des Standes der Technik zu überwinden, insbesondere die Horden, und somit die Scheiben, in einer definierten Position anzuordnen.

Gegenstand der Erfindung ist eine Hordenaufnahmevorrichtung mit einer Befestigungsfläche 1, dadurch gekennzeichnet, daß sie zumindest zwei Seitenführungen 2 und zumindest einen Anschlag 3 aufweist, wobei der Anschlag 3 jeweils vor den zumindest zwei Seitenführungen 2 angeordnet ist und die zwei Seitenführungen 2 beabstandet parallel zueinander angeordnet sind, wobei die beiden Seitenführungen 2 so gestaltet sind, daß sie auf im wesentlichen gleicher Höhe eine Auflagefläche aufweisen.

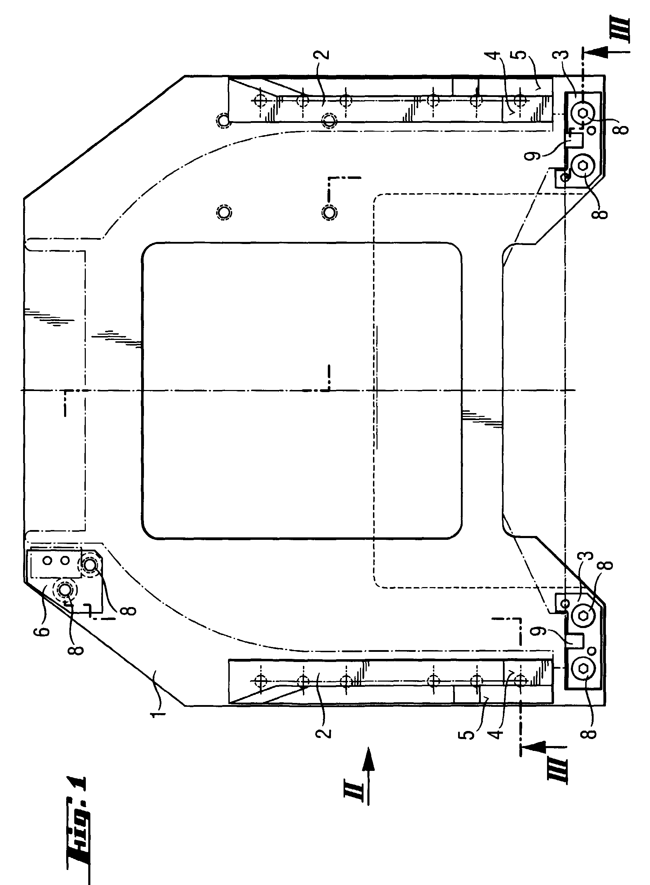

Figur 1 zeigt die Hordenaufnahmevorrichtung in Draufsicht.

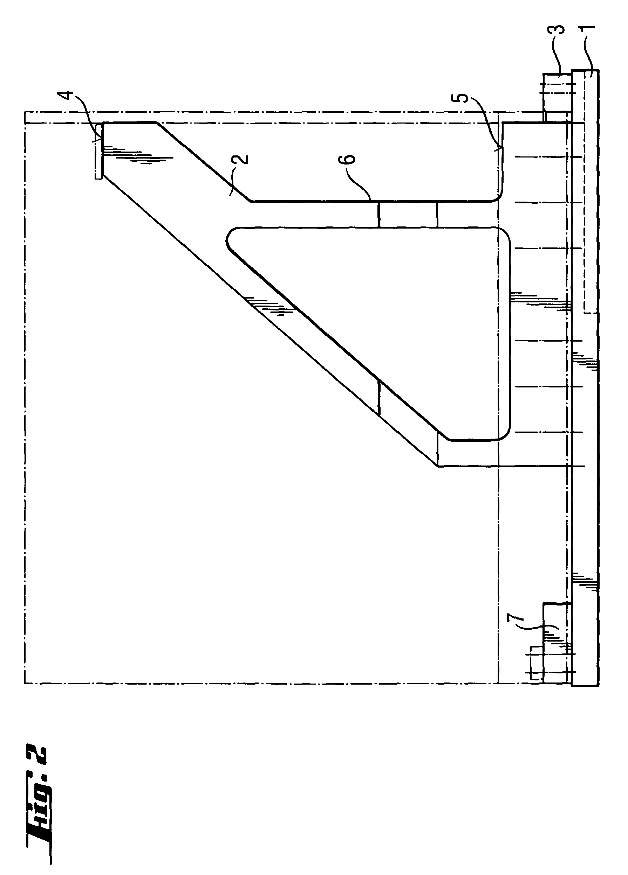

Figur 2 zeigt die Hordenaufnahmevorrichtung von der Seite.

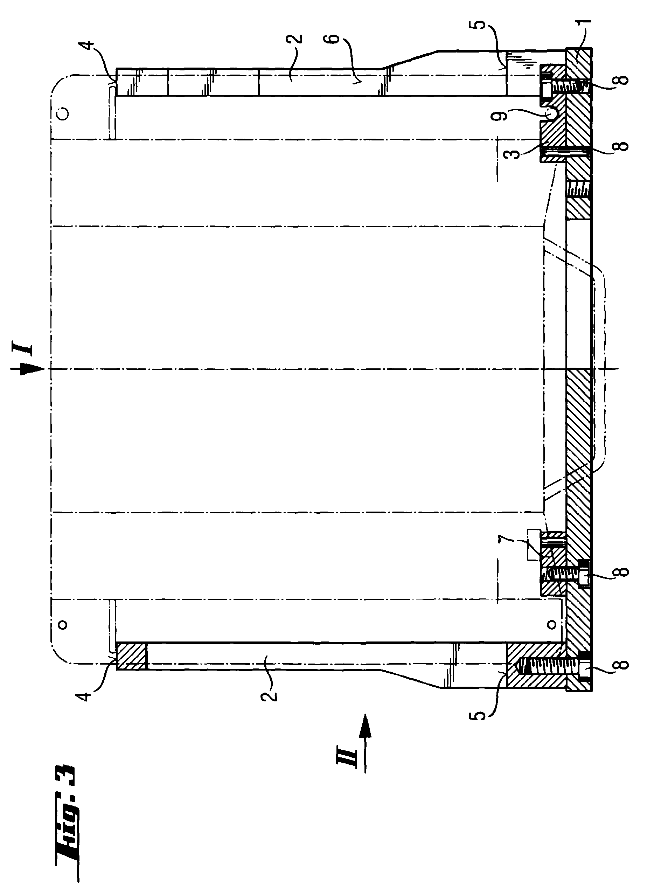

Figur 3 zeigt die Hordenaufnahmevorrichtung von der Stirnseite.

Die erfindungsgemäße Hordenaufnahmevorrichtung weist eine Befestigungsfläche 1 auf, auf der die zumindest zwei Seitenführungen 2 und der zumindest eine Anschlag 3 befestigt ist. Diese Elemente können vorzugsweise eine bewegliche Einheit bilden oder die Befestigungsfläche 1 ist Bestandteil einer anderen Vorrichtung, wie einer Meßvorrichtung oder einer Poliervorrichtung, wobei die bewegliche nicht stationäre Hordenaufnahmevorrichtung als Einheit beweglich ist. Die zumindest zwei Seitenführungen 2 sind parallel beabstandet zu einander angeordnet, so daß die Horden, vorzugsweise mit einer Auflagefläche z.B. einer Lasche aufliegen können. Dies geschieht vorzugsweise auf der vorzugsweise oberen planen Auflagefläche 4 der Seitenführungen 2. Falls die Horde um 180° gedreht wird, kommen diese Auflageflächen der Horde auf der unteren planen Auflagefläche 5 zum liegen. Eine erfindungsgemäße Seitenführung 2 weist entweder vorzugsweise nur die obere 4 oder die untere Auflagefläche 5 auf oder bevorzugt beide Auflageflächen 4 und 5 auf. Dabei kann zwischen den Auflageflächen 4 und 5 eine Aussparung 6 sein, was bevorzugt ist. Vorstellbar ist jedoch auch ein Schlitz auf der Höhe der unteren Auflagefläche 5, so daß eine Scheibe eingeschoben werden kann. Der Abstand der beiden Auflageflächen wird vorzugsweise so gewählt, daß die untere Scheibe in der Horde immer, ob sie nun oben auf der Auflagefläche 4 oder auf der Auflagefläche 5 aufliegt, also die Horde um 180 ° gedreht wurde, den gleichen Abstand zur Befestigungsfläche aufweist.

Der zumindest eine Anschlag 3 ist vor der Stirnseite der Seitenführung 2 angeordnet, so daß die Horde sich an dem Anschlag nach vorne abstützen kann. Falls es ein einziger Anschlag ist, wird dieser vorzugsweise in der Mitte zwischen den Seitenführungen 2 angeordnet. Bevorzugt sind jedoch zwei Anschläge 3, die jeweils vor den jeweiligen Seitenführungen so angeordnet sind, daß sich die Horde an beiden Seiten nach vorne abstützen kann. Die Anschläge 3 weisen in einer bevorzugten Ausführungsform Aussparungen 9 auf, die einen oder mehrere Nippel, die sich an der Horde befinden, aufnehmen können und so der Horde eine zusätzliche Stabilität verleihen. Auf der Befestigungsplatte befindet sich, vorzugsweise im hinteren Teil ein Sensor 7, der feststellt, ob die Horde aufliegt. Die Anschläge 3, Seitenführungen 2 und der Sensor 7 sind mit Befestigungsmitteln 8, vorzugsweise Schrauben, auf der Befestigungsfläche 1 befestigt.

Die Vorteile der erfindungsgemäßen Hordenaufnahme sind, daß die Horde in ihnen nicht verkanntet oder verzogen wird, so daß ein Greifer die Scheiben richtig zu fassen bekommt, so daß die wertvollen Scheiben nicht zerstört oder beschädigt werden. Des weiteren biegen sich die Horden nicht mehr durch, so daß der Sensor nun immer erkennt, daß sich eine Horde in der Hordenaufnahmevorrichtung befindet und die entsprechende Poliermaschine oder Meßvorrichtung korrekt arbeiten kann. Somit befindet sich die Scheibe immer, im Bezug auf den Greifer des Roboters, an der gleichen Stelle und es treten somit keine Handhabungsfehler mehr auf, die früher 80 % der Fehler betragen haben.

## Patentansprüche

1. Hordenaufnahmevorrichtung mit einer Befestigungsfläche 1, dadurch gekennzeichnet, daß sie zumindest zwei Seitenführungen 2 und zumindest einen Anschlag 3 aufweist, wobei der Anschlag 3 jeweils vor den zumindest zwei Seitenführungen 2 angeordnet ist und die zwei Seitenführungen 2 beabstandet parallel zueinander angeordnet sind, wobei die beiden Seitenführungen 2 so gestaltet sind, daß sie auf im wesentlichen gleicher Höhe eine Auflagefläche aufweisen.

2. Hordenaufnahmevorrichtung nach Anspruch 1, dadurch gekennzeichnet, daß die beiden Seitenführungen 2 sowohl oben und unten eine Auflagefläche aufweisen.
